# EUROPÄISCHE PATENTSCHRIFT

(11) **EP 2 304 371 B1**
(45) Veröffentlichungstag und Bekanntmachung des Hinweises auf die Patenterteilung: **02.11.2011**
(21) Anmeldenummer: 09760075.3
(22) Anmeldetag: 10.06.2009
(51) Int. Cl.: F28D 20/02, F28F 13/16

(54) **VORRICHTUNG UND VERFAHREN ZUR KÜHLUNG VON BAUTEILEN MITTELS MAGNETISIERBAREM PHASENWECHSELMATERIAL**
DEVICE AND METHOD FOR COOLING COMPONENTS BY MEANS OF MAGNETIZABLE PHASE CHANGE MATERIAL
DISPOSITIF ET PROCÉDÉ POUR REFROIDIR DES COMPOSANTS AU MOYEN DE MATÉRIAU À CHANGEMENT DE PHASE MAGNÉTISABLE

(30) Priorität: 09.07.2008 DE 102008040281
(43) Veröffentlichungstag der Anmeldung: 06.04.2011
(73) Patentinhaber: Robert Bosch GmbH, 70442 Stuttgart (DE)
(72) Erfinder: DANNER, Reinhold, 72108 Rottenburg (DE); LISCHECK, Andre, 71665 Vaihingen/Enz (DE); SCHULZ, Udo, 71665 Vaihingen/Enz (DE); PROEPPER, Thomas, 72762 Reutlingen (DE); BARTH, Heinrich, 71229 Leonberg (DE)
(86) Internationale Anmeldenummer: PCT/EP2009/057191
(87) Internationale Veröffentlichungsnummer: WO 2010/003755

(56) Entgegenhaltungen:
- GB-A- 1 255 331
- US-A- 3 596 713
- US-A- 4 366 857
- US-A- 6 052 992
- US-A1- 2002 053 418
- US-A1- 2004 093 877
- US-A1- 2008 029 247
- US-A1- 2008 062 648

## Beschreibung

### Stand der Technik

Die Erfindung geht aus von einer Vorrichtung zu Kühlung von Bauteilen gemäß dem Oberbegriff des Anspruchs 1. Weiterhin betrifft die Erfindung ein Verfahren zur Kühlung eines Bauteils unter Verwendung der Vorrichtung.

Bauteile, die gekühlt werden müssen, sind z.B. kompakte elektronische Baugruppen mit hochintegrierten Schaltungen (ASICs) und digitale Mikrocontroller, in denen hohe Verlustleistungsdichten entstehen können. Bei einer hohen elektrischen Leistungsaufnahme und insbesondere in transienten Lastzuständen können sich hochintegrierte elektronische Schaltungen aufgrund der unvermeidlichen ohmschen oder dielektrischen Verluste schnell erwärmen. Unzulässig hohe Innenternperaturen an den pn-Übergängen der Halbleiter können jedoch zu Fehlfunktionen, vorzeitiger Alterung und Ausfall der gesamten Baugruppe führen, weshalb die innere thermische Energie an die Systemumgebung abgeführt werden muss.

Die Wärmeabfuhr erfolgt z.B. durch passive Diffusionskühlung oder die technisch aufwändige konvektive Kühlmittelumwälzung mittels Turbo- oder Verdrängerpumpen. Hierbei nimmt das umgewälzte Kühlfluid Wärme an der heißen Oberfläche eines Bauelements auf und überträgt diese auf einen Wärmeübertrager mit großer Oberfläche. Üblicherweise weist die Oberfläche des Wärmeübertragers dünne Lamellen oder Rippen auf der Systemoberfläche auf. Günstig wirkt sich eine Medienströmung an der Außenoberfläche aus, die den Wärmetransfer behindernden Grenzschichteffekten entgegenwirkt.

Eine Wärmeübertragung erfolgt jeweils von einer Oberfläche höherer Temperatur zu einer Oberfläche niedrigerer Temperatur. Im thermischen Gleichgewicht erfolgt kein Energieaustausch mit der Systemumgebung.

Neben Diffusionskühlung und konvektiver Kühlung ist auch die elektrische Kühlung durch Peltier-Elernente bekannt. Diese sind jedoch vergleichsweise teuer, vergrößern die elektrische Leistungsaufnahme der Elektronik und beanspruchen unter Umständen mehr Bauraum als die zu kühlenden elektronischen Bauelemente selbst. Aus diesem Grund kommen Peltier-Elemente für die breite Anwendung nicht in Frage.

Neben konvektiver Kühlmittelumwälzung mittels Turbo- oder Verdrängerpumpen ist auch eine passive Kühlfluidumwälzung nach dem Prinzip selbst aufrechterhaltender Konvektion in Gestalt so genannter Thermosyphons bekannt. Diese setzt jedoch eine Orientierung des Wärmestroms parallel zum Schwerefeld voraus. In der Computerelektronik werden zur Kühlung auch Wärmerohre (Heat pipes) eingesetzt, die ebenfalls nach dem Prinzip passiver Kühlfluidumwälzung funktionieren. Ein Wärmerohr ist ein hermetisch abgeschlossenes System zum Wärmetransfer durch Verdampfungskühlung und selbst aufrechterhaltende Kühlmittelkonvektion. Die Siedetemperatur eines im Wärmerohr eingesetzten Kühlfluids liegt im thermischen Betriebsbereich einer zu kühlenden Wärmequelle. Die Flüssigphase benetzt die Innenwand eines dünnen Rohres und die Gasphase kann angetrieben vom Gasdruck im Inneren des Rohres zur Wärmesenke strömen und die Verdampfungswärme dort an einen Wärmetauscher abgeben. Hierbei kondensiert der Dampf. Das Fluid benetzt die Rohrinnenwände und strömt angetrieben vom Kapillareffekt zur Wärmequelle zurück. Um die Strömung aufgrund des Kapillareffektes zu verbessern, ist die Innenwand des Wärmerohres üblicherweise mit einer Kapillarstruktur versehen.

Wenn jedoch thermischer Kontakt zur Systemumgebung technisch nicht möglich oder nicht erwünscht ist, können Latentwärmespeicher eingesetzt werden, die Wärme von einer Wärmequelle aufnehmen. Dies ist insbesondere vorteilhaft, wenn im Lastprofil der Anwendung vorübergehende thermische Leistungsspitzen abzufangen sind. So ist z.B. die Abkühlung durch Diffusion oder Luftkonvektion von elektronischen Steuergeräten in einem Motorraum eines Kraftfahrzeuges bei vorübergehender rascher Zunahme der Umgebungstemperaturen, beispielsweise während der Langsamfahrt oder des Stillstands des Fahrzeuges nach längerem Betrieb im Volllastbereich des Motors möglicherweise nicht mehr ausreichend. In diesem Fall kommen die Vorteile der latenten Wärmespeicherung zur Geltung. Anstatt die Verlustwärme z.B. durch Diffusion oder Kühlmittelkonvektion auf die Systemoberfläche zu übertragen, wird sie an ein Phasenwechselmaterial (Phase Change Material, PCM) abgegeben. Im Koexistenzbereich der Fest- und Flüssigphase sowie der Flüssig- und Gasphase eines PCM führt eine Wärmezufuhr nicht zur Temperaturerhöhung sondern zu einer Entropieänderung im Wechsel des Aggregatszustandes oder des Ordnungszustandes, z.B. durch Verringerung der magnetischen Polarisation oder Verlust der kristallinen Fernordnung.

Beim Phasenwechsel durch Wärmeaufnahme oder Wärmeabgabe bleibt die Temperatur des PCM im Wesentlichen konstant. Jedoch kann in der Grenzschicht zur Wärmequelle die lokale Temperatur beispielsweise der Flüssigphase aufgrund ihrer schlechteren Wärmeleitfähigkeit im Vergleich zur festen Phase mit zunehmender Schichtdicke größer werden als die Schmelztemperatur. Es bildet sich ein Temperaturgefälle zwischen der Festphase und dem zu kühlenden Bauelement aus.

Zur Kühlung eingesetzte Latentwärmespeicher, die ein Phasenwechselmaterial enthalten, sind z.B. in WO-A 2007/075130 oder US-A 2002/0164277 beschrieben, die jeweils den Oberbegriff des Anspruchs 1 offenbaren.

### Offenbarung der Erfindung

### Vorteile der Erfindung

Eine erfindungsgemäß ausgebildete Vorrichtung zur Kühlung von Bauteilen umfasst ein Gehäuse mit einem darin ausgebildeten Hohlraum, in dem ein Phasenwechselmaterial aufgenommen ist. Das Gehäuse weist mindestens eine Fläche auf, die mit dem zu kühlenden Bauteil kontaktierbar ist, und mindestens eine wärmeabgebende Fläche. Der das Phasenwechselmaterial enthaltende Hohlraum ist von mindestens zwei Spulen umschlossen und das Phasenwechselmaterial enthält ferromagnetische oder magnetisierbare Partikel.

Die Vorrichtung eignet sich insbesondere zur Ableitung und Latentspeicherung der Verlustwärme elektronischer oder mechanischer Apparaturen. So kann die Vorrichtung z.B. eingesetzt werden zur Kühlung und Temperaturstabilisierung elektronischer Steuergeräte in Kraftfahrzeugen, insbesondere im Betrieb mit vorübergehenden thermischen Lastspitzen bei gleichzeitiger Grundlast. Diese treten z.B. auf während des Regenerationsbetriebes von Diesel-Partikelfiltern mit mehreren elektronisch gesteuerten Nacheinspritzungen des Motors oder nach längerem Betrieb im Volllastbereich des Motors und anschließender Langsam- oder Stop-and-go-Fahrt, wenn im Motor hohe Temperaturen bei gleichzeitig schlechter Luftkonvektion herrschen.

Die Vorrichtung dient insbesondere zur Latentspeicherung und dem gleichzeitigen Transfer von Verlustwärme. Die Latentspeicherung und der Transfer von Verlustwärme erfolgt nach dem erfindungsgemäßen Verfahren zur Kühlung eines Bauteils unter Verwendung der Vorrichtung. Das Verfahren umfasst folgende Schritte:
(a) Erzeugen eines Magnetfeldes im Phasenwechselmaterial durch Bestromen der Spulen,
(b) Schmelzen eines Teils des Phasenwechselmaterials durch Wärmeaufnahme auf der Seite, die dem zu kühlenden Bauteil zugewandt ist,
(c) Umkehren des Magnetfeldes durch Richtungsumkehr der Bestromung der Spulen und Drehen des nicht geschmolzenen Teils des Phasenwechselmaterials, wodurch das geschmolzene Phasenwechselmaterial zu der wärmeabgebenden Fläche hinbewegt wird und festes Phasenwechselmaterial zu der Oberfläche, an der Wärme aufgenommen wird,
(d) Schmelzen eines Teils des festen Phasenwechselmaterials, das dem zu kühlenden Bauteil zugewandt ist, und orientiertes Erstarren des der wärmeabgebenden Fläche zugewandten flüssigen Phasenwechselmaterials im Magnetfeld der Spulen,
(e) gegebenenfalls Wiederholen der Schritte (c) und (d).

Durch die Spulen und die im Phasenwechselmaterial enthaltenen ferromagnetischen oder magnetisierbaren Partikel, die es ermöglichen, dass der nicht geschmolzene Teil des Phasenwechselmaterials durch Richtungsumkehr der Bestromung der Spulen und dem dadurch umgekehrten Magnetfeld gedreht wird, arbeitet die erfindungsgemäße Vorrichtung einerseits als Latentwärmespeicher und andererseits als magnetisch angetriebene, verschleißfrei Verdrängerpumpe, deren Rotationskolben aus der Festphase des Phasenwechselmaterials besteht, und die ohne zusätzliche mechanische Teile arbeitet. Der Rotationskolben bildet sich durch periodisches Aufschmelzen und orientiertes Erstarren im Arbeitszyklus immer wieder neu. Die Vorrichtung kann z.B. eingesetzt werden in Anwendungen, die eine mit Verdränger- oder Turbopumpen angetriebene Umwälzung fluider oder gasförmiger Kühlmedien nicht zulassen. Auch kann die Vorrichtung in Anwendung mit einem transienten Lastprofil auf die mittlere thermische Verlustleistung ausgelegt werden, da Verlustwärme gleichzeitig sowohl übertragen als auch latent gespeichert wird. Eine Auslegung auf den - in der Regel selten auftretenden - Grenzfall wie bei passiver Diffusionskühlung ist nicht erforderlich.

Ein weiterer Vorteil ist, dass die Vorrichtung geräuschfrei arbeitet und widerstandsfähig gegen mechanische oder chemische Einwirkung ist und zudem keine verschleißbehafteten Elemente aufweist. Auch ist die notwendige elektrische Leistungsaufnahme zur Drehung des als Verdrängerkolben wirkenden festen, orientiert magnetisierten Teils des Phasenwechselmaterials sehr gering.

Ein weiterer Vorteil ist, dass Pumpen, Schlauchverbindungen, Stopfbuchsen oder Verschraubungen, die bei konvektiven Kühlsystemen erforderlich sind, nicht benötigt werden. Das Phasenwechselmaterial ist in ein massives Gehäuse hermetisch eingeschlossen. Flüssigphase und Gasphase des Phasenwechselmaterials können bei entsprechender Innendruckfestigkeit des Gehäuses nicht austreten.

Durch entsprechende Steuerung der Spulen zur Umkehr des Magnetfeldes kann der Übergang von der Latentwärmespeicherung zum Wärmetransfer gleitend gesteuert und geregelt werden. Es können beide Prozesse gleichzeitig ablaufen. Da sich zwischen der Wärmequelle und der Festphase des Phasenwechselmaterials nur eine dünne Flüssigkeitsschicht als Wärmestrombarriere befindet, ist stets ein hoher Transferwärmestrom gewährleistet.

Durch die im Phasenwechselmaterial enthaltenen ferromagnetischen oder magnetisierbaren Partikel nimmt die Vorrichtung zusätzlich zur Schmelzwärme auch thermische Energie durch Entropieerhöhung auf, indem die magnetische Ordnung der in das Phasenwechselmaterial eingeschlossenen ferromagnetischen oder magnetisierbaren Partikel durch Aufschmelzen verringert wird.

Ein weiterer Vorteil der ferromagnetischen oder magnetisierbaren Partikel im Phasenwechselmaterial ist, dass die durch Abschmelzen und Erstarren aufgenommene bzw. abgegebene Wärme sowie der abfließende und zufließende Wärmestrom über eine damit verbundene Veränderung der Magnetisierung des Phasenwechselmaterials auf einfache und genaue Weise anhand der Veränderung der Spuleninduktivitäten gemessen werden können. Auch lässt sich aus der Wärmestrombilanz und bekannten thermischen Materialparametern des Gehäuses und des Phasenwechselmaterials die Temperatur der Wärmesenke und der Wärmequelle bestimmten. Anhand dieser Größen wird die Taktrate des Umwälzzyklus gesteuert und damit gewährleistet, dass stets ausreichend Festphase des Phasenwechselmaterials in unmittelbarer Umgebung der Wärmequelle vorhanden ist und ein hoher Wärmestrom an der Wärmequelle aufrechterhalten wird.

Um das Umwälzen des Phasenwechselmaterials zu gewährleisten, ist es bevorzugt, dass der das Phasenwechselmaterial enthaltende Hohlraum mit einem kreisförmigen Querschnitt ausgebildet ist. Die zwei Spulen, die den das Phasenwechselmaterial enthaltenden Hohlraum umschließen, sind vorzugsweise derart zueinander ausgerichtet, dass die von den Spulen erzeugten Magnetfelder gleichgerichtet sein können. Vorzugsweise sind die Spulen derart angeordnet, dass eine Spule oberhalb einer Mittelebene des Hohlraumes und die zweite Spule unterhalb der Mittelebene des Hohlraumes angeordnet ist. Durch die Anordnung der Spulen lässt sich so durch entsprechende Ansteuerung und Ausrichtung des Magnetfeldes die Drehung des nicht geschmolzenen, magnetisch orientierten Teils des Phasenwechselmaterials realisieren.

Um das Latentwärmespeichervermögen zu erhöhen, ist es in einer Ausführungsform möglich, mindestens zwei Phasenwechselmaterial enthaltende Hohlräume in Transportrichtung der Wärme hintereinander anzuordnen. Hierbei kann von dem in jedem der Hohlräume enthaltenen Phasenwechselmaterial Wärme aufgenommen und gespeichert werden. Durch Rotation und anschließendes Erstarren wird diese dann wieder abgegeben. Bei einer großen zu kühlenden Oberfläche ist es weiterhin möglich, auch mehrere Phasenwechselmaterial enthaltende Hohlräume nebeneinander anzuordnen. Auch bei nicht-ebenen Oberflächen lässt sich auf diese Weise eine Anordnung erzielen, die eine optimale Kühlung gewährleistet, da bei nebeneinander angeordneten Hohlräumen mit darin enthaltenem Phasenwechselmaterial die Hohlräume auch in unterschiedlicher Höhe angebracht werden können und so an die Oberfläche des zu kühlenden Bauteiles angepasst werden können.

Um Bauraum einzusparen und eine Beschädigung der Spule zu vermeiden, ist es bevorzugt, dass die Spulen im Gehäuse aufgenommen sind. Alternativ ist es jedoch auch möglich, die Spulen z.B. außerhalb des Gehäuses anzuordnen.

Neben der Kühlung und Temperaturstabilisierung elektronischer Steuergeräte in Kraftfahrzeugen eignet sich die Vorrichtung zur Kühlung von Bauteilen auch zur Kühlung kompakter, integrierter elektrischer, mikromechanischer und elektronischer Baugruppen, die sich aufgrund der geringen Masse- und Wärmekapazität der Baugruppe bei thermischen Lastspitzen rasch erhitzen, angetriebenen Konvektionskühlungen keinen Bauraum lassen oder nicht genügend elektrische Antriebsleistung zur Verfügung stellen können und/oder einen Wärmetransfer an die unmittelbare Systemumgebung aufgrund eines thermisch ungünstigen Einbauorts oder konstruktiver Randbedingungen nicht zulassen. Ein Wärmetransfer an die unmittelbare Systemumgebung ist z.B. dann nicht möglich, wenn beispielsweise vorübergehend erhöhte Umgebungstemperaturen oder mechanische Beanspruchungen vorliegen oder eine Wärmeleitung aufgrund hoher thermischer Übergangswiderstände unzureichend ist. Dies ist z.B. neben den elektronischen Steuergeräten in Kraftfahrzeugen auch für Steuerrechner in unmittelbarer Nähe zu Fertigungs-, Verarbeitungs- oder Maschinenanlagen der Fall.

Wenn über mehrere Flächen des Gehäuses Wärme abgeführt werden kann, so kann die Vorrichtung auch als Wärmeweiche eingesetzt werden, die den von der Wärmequelle, d.h. dem zu kühlenden Bauteil, ausgehenden Wärmestrom auf verschiedene Wärmesenken umleiten und verteilen kann. Die Verteilung kann dabei kontinuierlich gesteuert und geregelt werden. Um das aufgeschmolzene Phasenwechselmaterial durch Drehung des nicht geschmolzenen Teils des Phasenwechselmaterials in Richtung einer wärmeabgebenden Fläche zu drehen, sind die mindestens zwei Spulen vorzugsweise derart zueinander ausgerichtet, dass das von den Spulen erzeugte Magnetfeld im Phasenwechselmaterial senkrecht zu der wärmeabgebenden Fläche ausgerichtet werden kann. Die Drehung erfolgt dabei jeweils soweit, dass die in Phasenwechselmaterial enthaltenen ferromagnetischen oder magnetisierbaren Partikel in Richtung der magnetischen Feldlinien des von den Spulen erzeugten Magnetfeldes ausgerichtet sind.

Der Wärmeübergang von der Wärmequelle zur Wärmesenke wird erfindungsgemäß mit der Taktfrequenz des Umwälzzyklus der flüssigen Phase des Phasenwechselmaterials gesteuert und über die induktive Bestimmung der Wärmestrombilanz geregelt. Wenn die Vorrichtung zur Kühlung elektronischer Baugruppen eingesetzt wird, so können die Spulen in Spannungswandlern, EMV-Drosseln oder als Induktivitäten mit einem Spulenkern variabler Magnetisierung verwendet werden.

### Kurze Beschreibung der Zeichnungen

Ausführungsbeispiele der Erfindung sind in den Zeichnungen dargestellt und in der nachfolgenden Beschreibung näher erläutert.

### Es zeigen:

- Figuren 1-6: Verfahrensschritte zur Kühlung eines Bauteils mit einer Vorrichtung in einer ersten Ausführungsform,
- Figur 7: eine Vorrichtung zur Kühlung von Bauteilen in einer zweiten Ausführungsform,
- Figur 8: eine Vorrichtung zur Kühlung von Bauteilen mit mehreren parallel und in Reihe geschalteten mit Phasenwechselmaterial gefüllten Hohlräumen,
- Figur 9: eine Vorrichtung zur Kühlung von Bauteilen mit mehreren parallel und in Reihe geschalteten Hohlräumen mit einem Phasenwechselmaterial in einer zweiten Ausfiihrungsforrn.

### Ausführungsformen der Erfindung

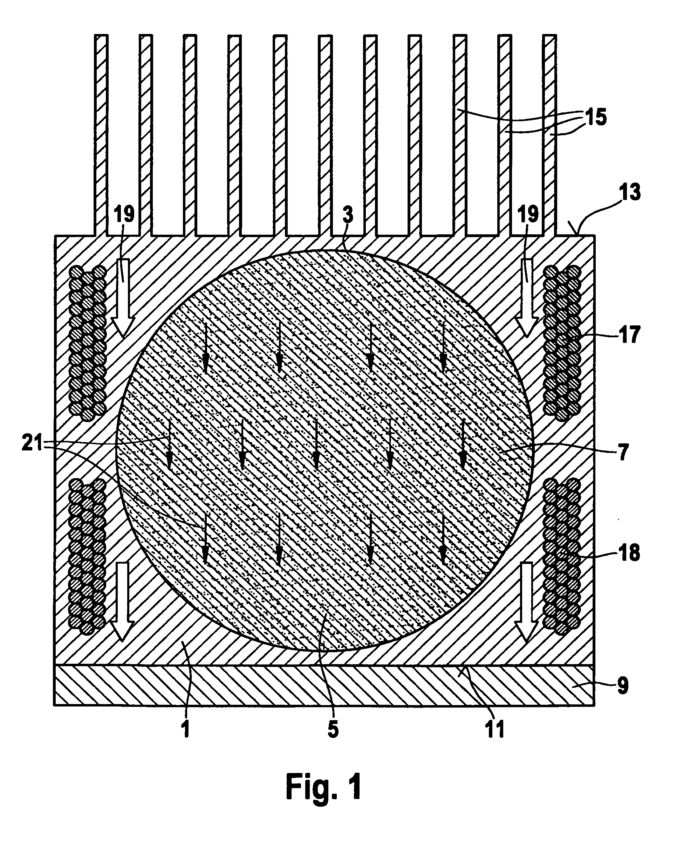

In den Figuren 1 bis 6 ist ein Verfahren zur Kühlung von Bauteilen in einer Vorrichtung zur Kühlung von Bauteilen in einer ersten Ausfiihrungsform dargestellt.

Eine erfindungsgemäß ausgebildete Vorrichtung zur Kühlung von Bauteilen umfasst ein Gehäuse 1, das aus einem gut wänneleitfähigen Material gefertigt ist. Als Material für das Gehäuse 1 eignen sich insbesondere metallische Werkstoffe. Besonders geeignet sind beispielsweise Kupfer oder Aluminium. In dem Gehäuse ist ein Hohlraum 3 ausgebildet. In der hier dargestellten Ausführungsform ist der Hohlraum 3 mit einem kreisförmigen Querschnitt ausgeführt. Der mit einem kreisförmigen Querschnitt ausgebildete Hohlraum 3 kann z.B. zylinderförmig, kugelförmig oder auch kegelförmig oder in Form eines Kegelstumpfes ausgebildet sein. Bevorzugt ist der Hohlraum 3 jedoch kugelförmig oder zylinderförmig. Im Hohlraum 3 ist ein Phasenwechselmaterial 5 enthalten. Das eingesetzte Phasenwechselmaterial 5 ist dabei abhängig von der Temperatur des zu kühlenden Bauteils. Als Phasenwechselmaterial eignen sich z.B. Paraffins, Wachse, Fette, Fettsäuren, Metalllegierungen, beispielsweise Bismut-Blei-Legierungen, oder niedrigschmelzende Salze. Welches Phasenwechselmaterial für welchen Temperaturbereich geeignet ist, ist dem Fachmann bekannt. Im Phasenwechselmaterial 5 sind ferromagnetische oder magnetisierbare Partikel 7 enthalten.

Eine zu kühlende Fläche 9 eines zu kühlenden Bauteils liegt an einer Oberfläche 11 des Gehäuses 1 an. Um einen möglichst optimalen Wärmeübergang vom zu kühlenden Bauteil an das Gehäuse 1 zu erzielen, ist es vorteilhaft, wenn zwischen der zu kühlenden Fläche 9 des zu kühlenden Bauteils und der Oberfläche 11 des Gehäuses 1 kein Spalt ausgebildet ist. Um einen gleichmäßigen Kontakt zu erzielen, ist es z.B. möglich, zwischen der zu kühlenden Fläche 9 des zu kühlenden Bauteils und der Oberfläche 11 des Gehäuses 1 eine Wärmeleitpaste einzubringen.

Neben der Oberfläche 11 des Gehäuses 1, die die zu kühlende Fläche 9 des zu kühlenden Bauteils kontaktiert, umfasst das Gehäuse 1 mindestens eine wärmeabgebende Fläche 13. Um die wärmeabgebende Fläche 13 zu vergrößern, sind an der wärmeabgebenden Fläche 13 vorzugsweise Rippen 15 ausgebildet. Die Rippen 15 sind dabei üblicherweise aus dem gleichen wärmeleitfähigen Material gefertigt wie das Gehäuse. Alternativ können die Rippen 15 auch aus einem vom Gehäusematerial verschiedenen Material gefertigt sein, das jedoch ebenfalls gut wärmeleitend ist.

Der das Phasenwechselmaterial 5 enthaltende Hohlraum 3 ist von mindestens einer Spule 17 umschlossen. In der hier dargestellten Ausführungsform ist der Hohlraum 3 von zwei Spulen 17 umschlossen. Hierbei befindet sich eine Spule 17 oberhalb einer Mittellinie des Hohlraums 3 und eine zweite Spule 17 unterhalb der Mittellinie des Hohlraums 3. Durch Anlegen einer Spannung an die Spulen 17 bildet sich ein Magnetfeld aus. Die Spulen 17 sind dabei zunächst so geschaltet, dass das von den Spulen 17 ausgebildete Magnetfeld im das Phasenwechselmaterial 5 enthaltenden Hohlraum 3 gleichgerichtet ist. Das von den Spulen 17 erzeugte Magnetfeld ist durch Pfeile 19 dargestellt. Die von den Spulen 17 erzeugten Magnetfelder können dabei gleichgerichtet oder gegengerichtet werden. In der hier dargestellten Ausführungsform sind die Magnetfelder 19 der Spulen 17 gleichgerichtet.

Zu Beginn der Wärmeabfuhr von der zu kühlenden Fläche 9 des zu kühlenden Bauteils liegt das Phasenwechselmaterial 5 in der Festphase vor. Die im Phasenwechselmaterial 5 enthaltenen ferromagnetischen oder magnetisierbaren Partikel sind entlang der Feldlinien des Magnetfeldes 19 orientiert. Um die Orientierung der ferromagnetischen oder magnetisierbaren Partikel 7 zu erzielen, erstarrt das Phasenwechselmaterial 5 im Magnetfeld 19 der Spulen 17. Die Ausrichtung der Partikel 7 ist durch Pfeile 21 angedeutet.

Als Material für die ferromagnetischen oder magnetisierbaren Partikel eignet sich jedes ferro- oder paramagnetische Material mit positiver magnetischer Suszeptibilität. Geeignete Materialien sind z.B. Eisen-Nickel-Legierungen, Eisen-Aluminium-Nickel-Kobalt-Legierungen oder Bismut-Mangan-Legierungen. Die ferromagnetischen oder magnetisierbaren Partikel 7 liegen vorzugsweise als Mikropartikel mit einem mittleren Partikeldurchmesser von im Allgemeinen weniger als 1 µm vor.

In einer bevorzugten Ausführungsform sind die im Phasenwechselmaterial 5 enthaltenen Partikel ferromagnetisch. In der Festphase ist das Phasenwechselmaterial 5 in diesem Fall remanent magnetisiert.

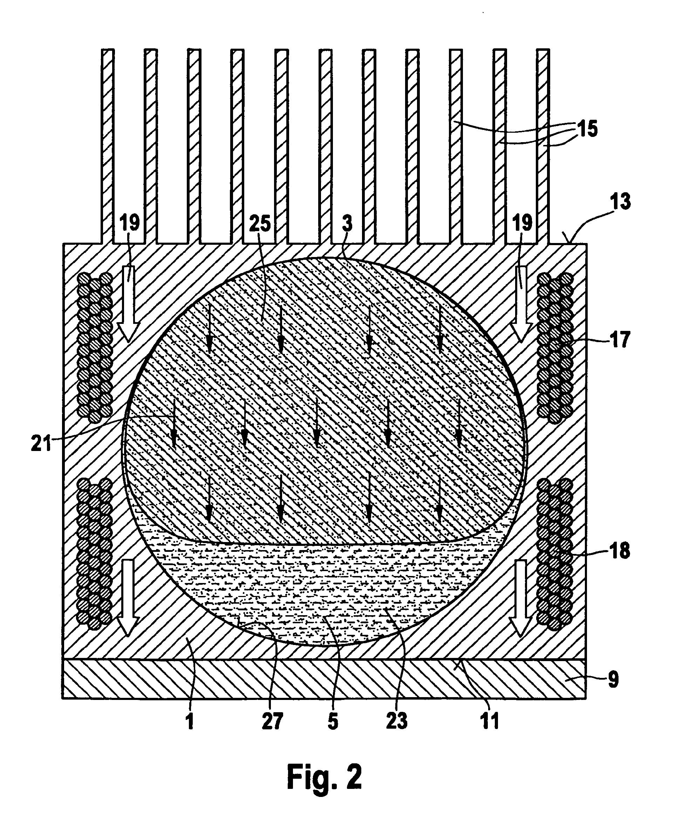

Durch den Kontakt der zu kühlenden Fläche 9 des zu kühlenden Bauteils mit der Oberfläche 11 des Gehäuses 1 wird Wärme vom zu kühlenden Bauteil an das Gehäuse 1 und durch Wärmeleitung durch das Gehäuse 1 an das Phasenwechselmaterial 5 übertragen. Das Phasenwechselmaterial 5 beginnt zu schmelzen, sobald die Schmelztemperatur des Phasenwechselmaterials erreicht ist. Durch das Schmelzen nimmt das Phasenwechselmaterial Wärme von dem zu kühlenden Bauteil auf. Auf der zur kühlenden Fläche 9 weisenden Seite geht das Phasenwechselmaterial 5 durch das Schmelzen in die Flüssigphase 23 über. Die verbleibende Festphase 25 des Phasenwechselmaterials 5 bildet einen exzentrischen Rotationskolben, der in Verbindung mit den Spulen 17 in Form einer zyklisch arbeitenden, magnetisch angetriebenen Verdrängerpumpe das Phasenwechselmaterial 5 in der Flüssigphase 23 durch Rotation von der zu kühlenden Fläche 9 in Richtung der wärmeabgebenden Fläche 13 fördert. Dieser Vorgang ist in den Figuren 2, 3 und 4 dargestellt.

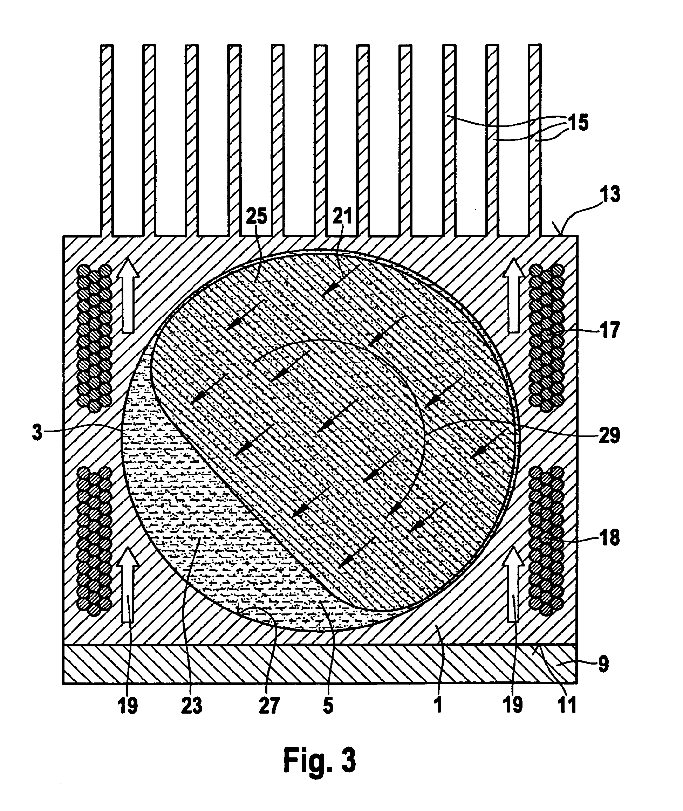

Das aufschmelzende Phasenwechselmaterial dehnt sich üblicherweise aus und die Flüssigphase 23 drängt sich zwischen die Festphase 25 des Phasenwechselmaterials 5 und die Wandung 27 des Hohlraums 3. Um die Haftung der Festphase 25 an der Wandung 27 des Hohlraums 3 im Bereich der wärmeabgebenden Fläche 13 zu überwinden und den von der Festphase 25 gebildeten Rotationskolben vollständig von der Wandung 27 des Hohlraums 3 zu lösen, wird mit der der zu kühlenden Fläche 9 zugewandten Spule 18 ein zum Dipolmoment des Phasenwechselmaterials gleichgerichtetes und mit der zur wärmeabgebenden Fläche 13 gerichteten Spule 17 ein entgegengerichtetes, vorzugsweise pulsierendes, Magnetfeld erregt. Durch eine geringfügige, zeitliche Pulsation der Feldstärke wird die Ablösung von der Wandung 27 des Hohlraums 3 und die Überwindung des oberen und unteren Totpunkts des Drehmoments im Magnetfeld 19 unterstützt. Hierdurch kommt die Festphase 25 als Rotationskolben der Umwälzpumpe von der Wandung 27 des Hohlraums 3 frei und kann sich nun in dem die gesamte Wandung 27 des Hohlraums 3 benetzenden Flüssigkeitsfilm frei drehen. Diese Drehung ist durch einen Pfeil 29 in Figur 3 dargestellt. Durch die Drehung der Festphase 29 wird die Flüssigphase 23 des Phasenwechselmaterials in Richtung der wärmeabgebenden Fläche 13 bewegt. Für die Drehung 29 der Festphase 25 wird das Magnetfeld 19, das von den Spulen 17, 18 erzeugt wird, zur ursprünglichen Richtung um 180° gedreht. Hierdurch ist das Magnetfeld 19 dem Ausgangsfeld entgegengerichtet.

Die Drehung 29 der Festphase 25 wird eingeleitet, sobald das induktiv bestimmte abgeschmolzene Volumen des Phasenwechselmaterials 5 und damit die zufließende Wärmemenge einen festgelegten Wert erreicht hat. Dieser wird über ein hier nicht dargestelltes Steuerungssystem ermittelt. Sobald dieser Wert erreicht ist, werden die gleichgerichteten Felder der Spulen 17, 18 umgekehrt. Das Dipolmoment des Phasenwechselmaterials steht damit antiparallel zum magnetischen Gleichfeld, dem eine geringfügige zeitliche Pulsation der Feldstärke überlagert wird, um den Rotationskolben, der durch die Festphase 25 des Phasenwechselmaterials 5 gebildet wird, aus dem instabilen Totpunkt des Drehmoments im Magnetfeld auszulenken. Die Festphase 25 dreht sich nun in den gegenüberliegenden stabilen Totpunkt, in dem ihr Dipolmoment parallel zum Feld steht. Hierdurch wird die Flüssigphase 23 des Phasenwechselmaterials 5 in den Bereich der wärmeabgebenden Fläche 13 gewälzt. Das Drehmoment, das die magnetisierte Festphase 25 des Phasenwechsehnaterials 5 erfährt, ist abhängig von der Winkelstellung der Festphase 25 und damit der Ausrichtung der Partikel 21 sowie der Stärke des Dipolmoment der magnetisierten Festphase 25 des Phasenwechselmaterials. Der Antrieb arbeitet wie ein geschalteter Reluktanzmotor.

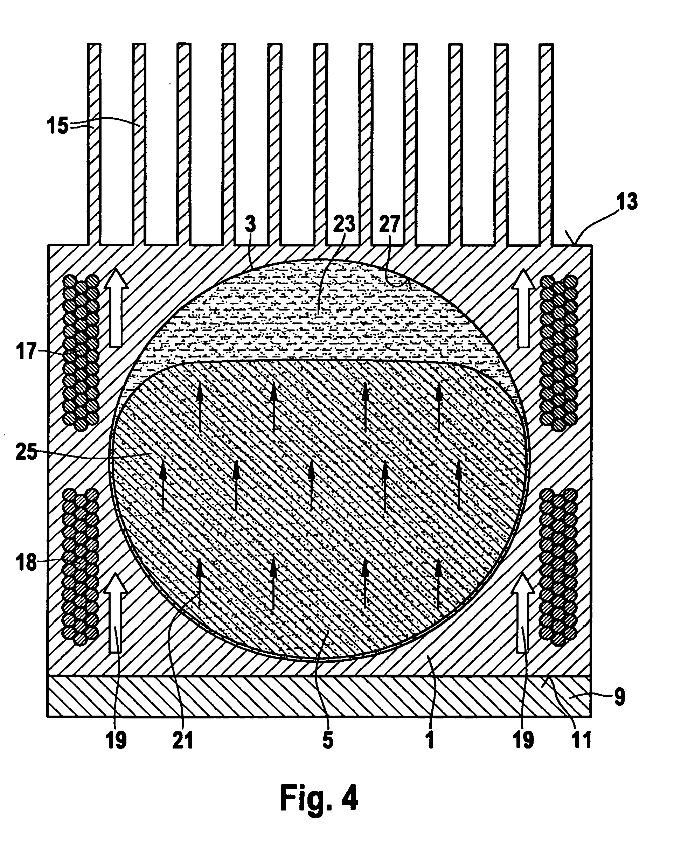

Sobald die Festphase 25 des Phasenwechselmaterials 5 eine halbe Drehung absolviert hat, befindet sich die Flüssigphase 23 auf der zur wärmeabgebenden Fläche 13 zugewandten Seite. Die Ausrichtung der Partikel 7 in der Festphase 25 entspricht wieder der Richtung des Magnetfeldes 19. Die Festphase 25 befindet sich in einer stabilen Position und die Drehung der Festphase 25 ist beendet. Dies ist in Figur 4 dargestellt.

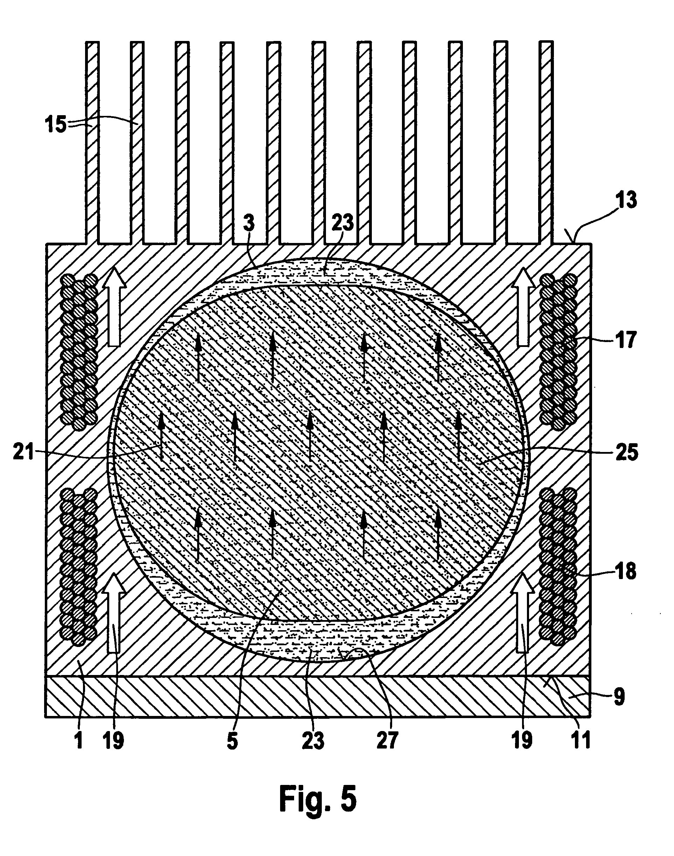

Sobald die Festphase 25 diese stabile Position erreicht hat, gibt die Flüssigphase 23 des Phasenwechselmaterials 5 Wärme über die wärmeabgebende Fläche 13 und die Rippen 15 ab. Hierzu ist es einerseits möglich, beispielsweise die wärmeabgebende Fläche 13 und die Rippen 15 mit einer Kühlflüssigkeit anzuströmen, üblicherweise wird jedoch die Wärme an die Umgebung abgegeben. Hierdurch wärmt sich die Luft der Umgebung auf und die Wärme wird durch freie Konvektion abtransportiert. Durch die Wärmeabgabe beginnt die Flüssigphase 23 zu erstarren. Durch das Magnetfeld 19, das durch die Spule 17 erzeugt wird, die die Flüssigphase 23 des Phasenwechselmaterials 5 umschließt, richten sich die in der Flüssigphase 23 des Phasenwechselmaterials 5 enthaltenen Partikel im Magnetfeld aus. Dies führt dazu, dass das erstarrte Phasenwechselmaterial weiterhin eine orientierte Magnetisierung aufweist. Zusätzlich zur latenten Schmelzwärme des Phasenwechselmaterials 5 geben die Partikel 7 durch die Orientierung aufgrund des Phasenübergangs in den ursprünglichen Zustand niedrigerer Entropie thermische Energie an die wärmeabgebende Fläche 13 und die Rippen 15 ab. Gleichzeitig mit der Erstarrung des Phasenwechselmaterials 5 an der gekühlten Seite wird von der zu kühlenden Fläche 9 des zu kühlenden Bauteils über die Oberfläche 11 des Gehäuses 1, die wärmeleitend mit der zu kühlenden Fläche 9 des zu kühlenden Bauteils verbunden ist, Wärme an die Festphase 25 des Phasenwechselmaterials 5 übertragen. Die Festphase des Phasenwechselmaterials beginnt zu schmelzen. Dies ist in Figur 5 dargestellt. Wenn vom Phasenwechselmaterial 5 genauso viel Wärme aufgenommen wird wie an der wärmeabgebenden Fläche 13 abgegeben werden kann, abgegeben wird, entspricht das Volumen des erstarrten Phasenwechselmaterials 5 dem Volumen des aufgeschmolzenen Phasenwechselmaterials 5. Wenn die Wärme schneller an die Umgebung abgegeben werden kann als vom Phasenwechselmaterial aufgenommen wird, so ist der Erstarrungsvorgang beendet, bevor die gleiche Menge an Phasenwechselmaterial 5 wieder aufgeschmolzen ist.

Um die Festphase 25 des Phasenwechselmaterials 5 in der stabilen Position zu erhalten, ist nur ein geringer Spulenstrom der Spulen 17, 18 erforderlich. Dieser ist auch ausreichend, damit sich die im Phasenwechselmaterial 5 enthaltenen ferromagnetischen oder magnetisierbaren Partikel 7 während des Erstarrungsvorganges ausrichten. Durch das fortschreitende Erstarren des Phasenwechselmaterials durch Wärmeabgabe nimmt die Magnetisierung der Festphase 25 des Phasenwechselmaterials 5 zu, bis ein stationäres Maximum erreicht ist. Die Induktivität der der wärmeabgebenden Fläche 13 zugewandten Spule 17 erreicht ebenfalls ein stationäres Maximum. Gleichzeitig nimmt durch das Aufschmelzen des Phasenwechselmaterials 5 und die damit verbundene Volumenzunahme der Flüssigphase 23 auf der der zu kühlenden Fläche 9 zugewandten Seite die Induktivität der Spule 18, die der zu kühlenden Fläche 9 zugewandt ist, ab. Ursache hierfür ist die Verringerung der magnetischen Polarisation in der Flüssigphase 23 des Phasenwechselmaterials 5, die zu einer Verringerung des orientiert magnetisierten Volumens der Festphase 25 führt. Die Veränderung der Induktivitäten der Spulen 17, 18 werden z.B. mit einer induktiven Wheatstoneschen Brückenschaltung und einem elektronischen Messgenerator in einer Steuerelektronik auf dem Fachmann bekannte Weise sehr genau bestimmt. Mit einer Steuereinheit, beispielsweise einem elektronischen Steuerrechner, wird abhängig von der Ge-stalt des Hohlraums 3 und des Gehäuses 1 ein zwei- oder drei-dimensionales, vereinfachtes Wärmediffusionsmodell auf Grundlage des Fickschen Gesetzes numerisch simuliert. Aus der induktiv bestimmten Erstarrungs- und Abschmelzgeschwindigkeit des Phasenwechselmaterials 5 werden mit diesem Modell der zufließende und abfließende Wärmestrom und mit der bekannten Ausgangstemperatur des Phasenwechselmaterials 5 und des Gehäuses 1 die Temperatur der zu kühlenden Fläche 9 und der Fläche 13 und der Rippen 15, über die Wärme abgegeben werden kann, sowie die aufgenommene thermische Energie errechnet.

Neben dem Einsatz einer induktiven Wheatstoneschen Brückenschaltung und einem elektronischen Messgenerator zur Bestimmung der Induktivitäten der Spulen 17, 18 ist es auch möglich, eine Analog-Digitalwandlung der gemessenen Spulenströme bei anliegender Wechselspannung bestimmter Amplitude und Frequenz durchzuführen.

Bei einem zylinderförmig ausgebildeten Hohlraum 3 ist es im Allgemeinen ausreichend, ein zweidimensionales Diffusionsmodell für die Simulation zu verwenden. Demgegenüber wird bei einem kugelförmigen Hohlraum 3 und damit einer Kugelgestalt der als Rotationskolben ausgebildeten Festphase 25 ein dreidimensionales Diffusionsmodell benötigt.

Je nach gestellten Genauigkeitsanforderungen und zur Verfügung stehender Rechenleistung der Steuereinheit kann das Diffusionsmodell neben Wärmekapazität und Wärmeleitfähigkeit des Materials des Gehäuses 1 und den Aggregatszuständen des Phasenwechselmaterials 5 auch den thermischen Ausdehnungskoeffizienten des Phasenwechselmaterials 5 sowie die thermischen Übergangswiderstände der Grenzschichten zwischen dem Gehäuse 1, der Festphase 25 und der Flüssigphase 23 berücksichtigen.

Durch das Aufschmelzen des Phasenwechselmaterials 5 gehen die zunächst in der Festphase 25 orientiert vorliegenden Partikel 7 aus dem geordneten Zustand niedriger Entropie in einen ungeordneten Zustand höherer Entropie über. Dieser Entropiezuwachs entzieht dem zu kühlenden Bauteil über die zu kühlende Fläche 9 zusätzlich thermische Energie. In einer bevorzugten Ausfiihrungsform sind die ferromagnetischen oder magnetisierbaren Partikel 7 von so geringer Ausdehnung, dass ihre magnetische Orientierung in der Flüssigphase 23 des Phasenwechselmaterials 5 im thermischen Gleichgewicht mit der Brownschen Bewegung der Moleküle statistisch gleichverteilt wird und damit die Magnetisierung des Phasenwechselmaterials 5 in der Flüssigphase 23 verschwindet.

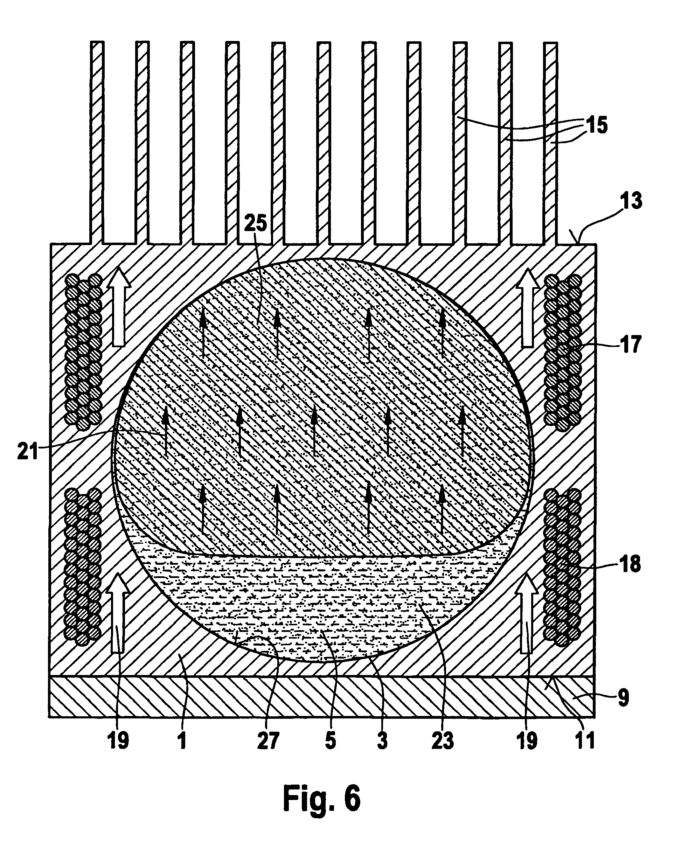

Sobald der der wärmeabgebenden Fläche 13 zugewandte flüssige Anteil des Phasenwechselmaterials 5 erstarrt ist und die Größe der Flüssigphase 23, die der zu kühlenden Fläche 9 zugewandt ist, wieder der zuvor aufgeschmolzenen Menge entspricht, wie dies in Figur 6 dargestellt ist, wird erneut das Magnetfeld der Spulen 17, 18 gegebenenfalls unter Pulsation umgekehrt, damit sich die Festphase 25 erneut dreht und die aufgeschmolzene Flüssigphase 23 wieder zur wärmeabgebenden Fläche 13 bewegt wird.

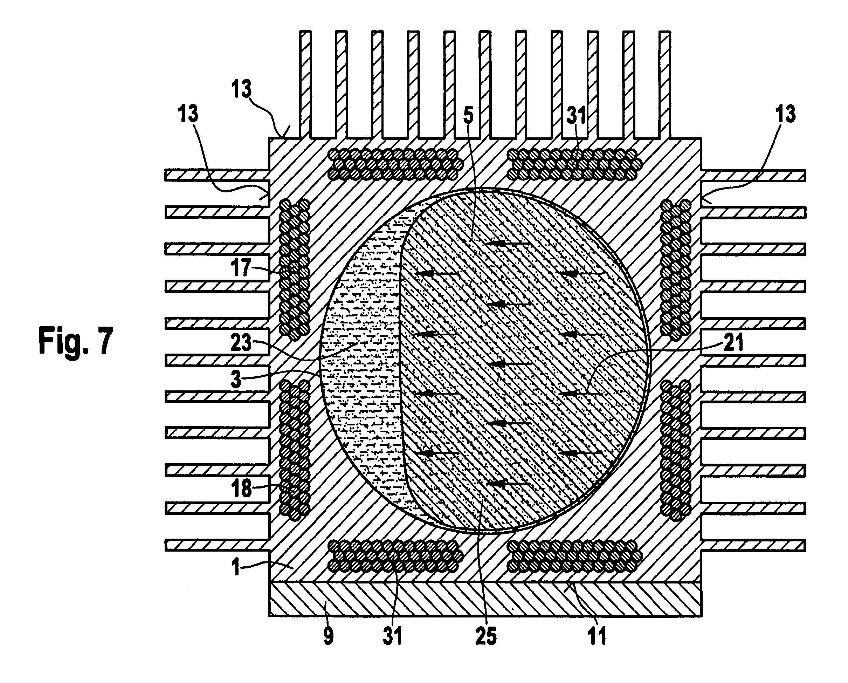

Sofern die Schmelzgeschwindigkeit des Phasenwechselmaterials 5 höher ist als die Erstarrungsgeschwindigkeit, fließt dem das Phasenwechselmaterial 5 enthaltenden Hohlraum 3 mehr Wärme zu als von diesem wieder abgegeben wird. Dieser Zustand wird über die Induktivitäten der Spulen 17, 18 erkannt. Damit der von der Festphase 25 des Phasenwechselmaterials 5 gebildete Rotationskolben nicht soweit abschmilzt, dass seine exzentrische Form verloren geht und die Drehung der Festphase 25 keine ausreichende Umwälzung der Flüssigphase 23 mehr bewirkt, wird die Frequenz des Umwälzzyklus entsprechend dem numerisch simulierten dynamischen Diffusionsmodell und damit auch der Wärmetransferstrom erhöht. Alternativ kann eine zusätzliche Wärmeabgabe vom Phasenwechselmaterial an die Umgebung auch dadurch erzielt werden, dass das Gehäuse 1 mehr als eine wärmeabgebende Fläche 13 aufweist. Dies ist beispielhaft für drei wärmeabgebende Flächen 13 in Figur 7 dargestellt. Hierbei sind die wärmeabgebenden Flächen 13 jeweils mit Rippen 15 versehen, um die Oberfläche zu vergrößern. In diesem Fall wird an jeder der wärmeabgebenden Flächen 13 Wärme vom Phasenwechselmaterial 5 an die Umgebung abgegeben, während gleichzeitig während der Wärmeabgabe Wärme von der zu kühlenden Fläche 9 des zu kühlenden Bauteils aufgenommen wird. Um auch eine stabile Ausrichtung des Phasenwechselmaterials zu den weiteren wärmeabgebenden Flächen 13 zu erzielen, sind zusätzliche Spulen 31 vorgesehen, die senkrecht zu den Spulen 17, 18 angeordnet sind.

Neben den dargestellten Anordnungen der Spulen 17, 18 und 31 ist jedoch auch jede beliebige andere Anordnung der Spulen, die dem Fachmann bekannt ist, und die geeignet ist, einsetzbar, mit der eine Drehung der Festphase 25 im Hohlraum 3 möglich ist.

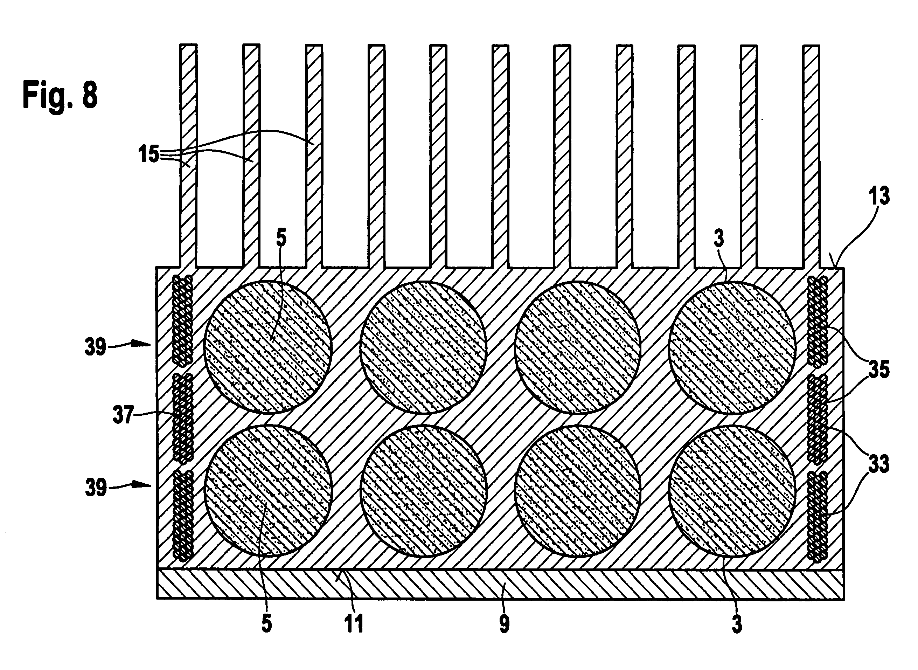

In Figur 8 ist eine alternative Ausführungsform einer erfindungsgemäßen Vorrichtung zur Kühlung von Bauteilen dargestellt.

Bei der in Figur 8 dargestellten Ausführungsform sind mehrere Hohlräume hintereinander und parallel im Gehäuse 1 angeordnet. Dies ermöglicht es, von einer größeren Fläche Wärme abzuführen. Um die erforderliche Drehung der Festphase 25 zu erzielen, ist es einerseits möglich, jeden Hohlraum mit Spulen zu versehen, alternativ und bevorzugt ist es jedoch auch möglich, wie in Figur 8 dargestellt, alle Hohlräume 3, die jeweils in einer Reihe liegen, von einem gemeinsamen Spulenpaar 33 zu umschließen. Hierbei ist es bevorzugt, dass ein erstes Spulenpaar 33 und ein zweites Spulenpaar 35, die jeweils nebeneinander angeordnete Hohlräume 3 umschließen, eine gemeinsame Spule 37 aufweisen. In einer Anordnung, wie sie in Figur 8 dargestellt ist, bei der mehrere Phasenwechselmaterial 5 enthaltende Hohlräume 3 nebeneinander und in Reihe angeordnet sind, ist es bevorzugt, wenn das Phasenwechselmaterial jeder Reihe 39 jeweils die gleiche Schmelztemperatur aufweist, aber das Phasenwechselmaterial 5 aufeinanderfolgender Reihen 39 unterschiedliche Schmelztemperaturen. Die Schmelztemperaturen neben dabei vorzugsweise von der zu kühlenden Fläche 9 hin zur wärmeabgebenden Fläche 13 ab. Hierdurch ergibt sich ein hohes Latentwärmespeichervermögen und im stationären Betriebszustand der Vorrichtung kommt ein hoher Wärmetransferstrom zwischen zu kühlender Fläche 9 des zu kühlenden Bauteils und der wärmeabgebenden Fläche 13 zustande.

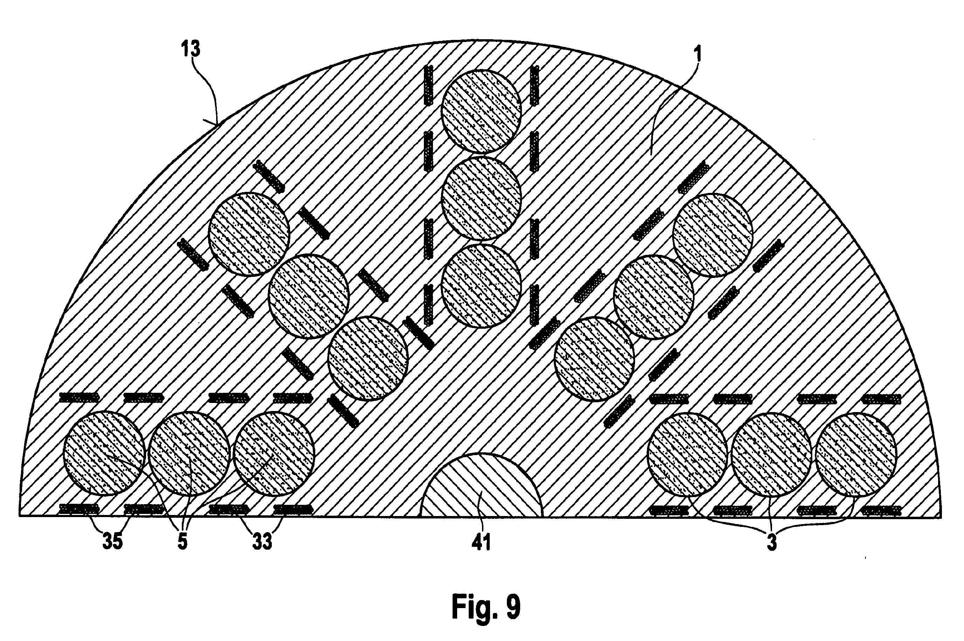

Eine weitere alternative Ausführungsform mit mehreren in Reihe und nebeneinander angeordneten Hohlräumen 3 ist in Figur 9 dargestellt. In diesem Fall sind die Hohlräume 3 kreisförmig in einem Gehäuse 1 um ein zu kühlendes Bauteil 41 angeordnet. Das zu kühlende Bauteil weist dabei ebenfalls eine kreisförmige Oberfläche auf. Hierbei kann es sich beispielsweise um eine kugelförmige Oberfläche oder eine kreiszylindrische Oberfläche handeln. So ist es z.B. auch möglich, dass das Bauteil 41 als Halbkugel ausgestaltet ist. Auch in der in Figur 9 dargestellten Ausführungsform ist es bevorzugt, dass das Phasenwechselmaterial 5, das in hintereinander geschalteten Hohlräumen 3 enthalten ist, unterschiedliche Schmelztemperaturen aufweist, wobei die Schmelztemperatur des Phasenwechselmaterials vom zu kühlenden Bauteil 41 zur wärmeabgebenden Fläche 13 hin abnimmt.

Aufgrund der Anordnung der Hohlräume 3 im Gehäuse 1 ist es bei der in Figur 9 dargestellten Ausführungsform erforderlich, jeweils einen Hohlraum 3 von einem Spulenpaar 33, 35 zu umschließen. Bei drei hintereinander angeordneten Hohlräumen 3, wie sie in Figur 9 dargestellt sind, ist es möglich, dass jeweils eine Spule des ersten Spulenpaars 33 und eine Spule des zweiten Spulenpaars 35 ein Spulenpaar bilden, das den mittleren Hohlraum 3 umschließt, um das im mittleren Hohlraum 3 erforderliche Magnetfeld zu erzeugen. Insbesondere bei der in Figur 9 dargestellten Ausführungsform mit einer hemisphärischen oder als Kugelkalotte gestalteten wärmeabgebenden Fläche 13 ist das eingesetzte Diffusionsmodell zur Berechnung des zufließenden und abfließenden Wärmestroms sowie der Temperatur der Oberfläche des zu kühlenden Bauteils 41 und der wärmeabgebenden Fläche 13 sowie die aufgenommene thermische Energie, im Wesentlichen kugelsyrnmetrisch.

## Patentansprüche

1. Vorrichtung zur Kühlung von Bauteilen (41), umfassend ein Gehäuse (1) mit einem darin ausgebildeten, innerhalb des Gehäuses (1) geschlossenen Hohlraum (3), in dem ein Phasenwechselmaterial (5) aufgenommen ist, wobei das Gehäuse (1) mindestens eine Fläche (11), die mit dem zu kühlenden Bauteil (41) kontaktierbar ist, und mindestens eine wärmeabgebende Fläche (13) aufweist, **dadurch gekennzeichnet, dass** der das Phasenwechselmaterial (5) enthaltende Hohlraum (3) von mindestens einer Spule (17, 18) umschlossen ist und das Phasenwechselmaterial (5) ferromagnetische oder magnetisierbare Partikel (7) enthält.

2. Vorrichtung gemäß Anspruch 1, **dadurch gekennzeichnet, dass** der das Phasenwechselmaterial (5) enthaltende Hohlraum (3) mit einem kreisförmigen Querschnitt ausgebildet ist.

3. Vorrichtung gemäß Anspruch 1 oder 2, **dadurch gekennzeichnet, dass** der das Phasenwechselmaterial (5) enthaltende Hohlraum (3) von mindestens zwei Spulen (17, 18) umschlossen ist und die mindestens zwei Spulen (17,18) derart zueinander ausgerichtet sind, dass von den Spulen (17, 18) erzeugte Magnetfelder (19) im Phasenwechselmaterial (5) gleichgerichtet sein können.

4. Vorrichtung gemäß einem der Ansprüche 1 bis 3, **dadurch gekennzeichnet, dass** das von den Spulen (17, 18) im Phasenwechselmaterial (5) erzeugte Magnetfeld (19) senkrecht zu einer wärmeabgebenden Fläche (13) ausgerichtet werden kann.

5. Vorrichtung gemäß einem der Ansprüche 1 bis 4, **dadurch gekennzeichnet, dass** mindestens zwei Phasenwechselmaterial (5) enthaltende Hohlräume (3) in Transportrichtung der Wärme hintereinander angeordnet sind.

6. Vorrichtung gemäß einem der Ansprüche 1 bis 5, **dadurch gekennzeichnet, dass** die Spulen (17, 18, 31) im Gehäuse aufgenommen sind.

7. Verfahren zur Kühlung eines Bauteils (41) unter Verwendung einer Vorrichtung gemäß einem der Ansprüche 1 bis 6, folgende Schritte umfassend:
(a) Erzeugen eines Magnetfelds (19) im Phasenwechselmaterial (5) durch Bestromen der Spulen (17, 18),
(b) Schmelzen eines Teils des Phasenwechselmaterials (5) durch Wärmeaufnahme auf der Seite, die dem zu kühlenden Bauteil (41) zugewandt ist,
(c) Umkehren des Magnetfeldes (19) durch Richtungsumkehr der Bestromung der Spulen (17, 18, 31) und Drehen des nicht geschmolzenen Teils des Phasenwechselmaterials (5), wodurch das geschmolzene Phasenwechselmaterial (5) zu der wärmeabgebenden Fläche (13) hinbewegt wird und festes Phasenwechselmaterial (5) zu der Oberfläche (11), an der Wärme aufgenommen wird,
(d) Schmelzen eines Teils des festen Phasenwechselmaterials (5), das dem zu kühlenden Bauteil (41) zugewandt ist, und orientiertes Erstarren des der wärmeabgebenden Fläche (13) zugewandten flüssigen Phasenwechselmaterials (5) im Magnetfeld (19) der Spulen (17, 18, 31),
(e) gegebenenfalls Wiederholen der Schritte (c) und (d).

8. Verfahren gemäß Anspruch 7, **dadurch gekennzeichnet, dass** aus der Änderung der Magnetisierung der im Phasenwechselmaterial (5) enthaltenen ferromagnetischen oder magnetisierbaren Partikel (7) aufgrund des Phasenwechsels der zugeführte beziehungsweise abgeführte Wärmestrom und die aufgenommene beziehungsweise abgegebene Wärmemenge bestimmt werden.

9. Verfahren gemäß Anspruch 8, **dadurch gekennzeichnet, dass** die Änderung der Magnetisierung aus der Veränderung der Spuleninduktivitäten bestimmt wird.

10. Verfahren gemäß Anspruch 8 oder 9, **dadurch gekennzeichnet, dass** aus dem zugeführten beziehungsweise abgeführten Wärmestrom und der aufgenommenen beziehungsweise abgegebenen Wärmemenge bestimmt wird, in welcher Frequenz das Magnetfeld umgekehrt wird.

## Claims

1. Apparatus for the cooling of components (41), comprising a housing (1) with a cavity (3) which is formed therein and is closed within the housing (1) and in which a phase change material (5) is accommodated, the housing (1) having at least one surface (11), which is contactable with the component (41) to be cooled, and at least one heat-emitting surface (13), **characterized in that** the cavity (3) containing the phase change material (5) is surrounded by at least one coil (17, 18) and the phase change material (5) contains ferromagnetic or magnetisable particles (7).

2. Apparatus according to Claim 1, **characterized in that** the cavity (3) containing the phase change material (5) is formed with a circular cross section.

3. Apparatus according to Claim 1 or 2, **characterized in that** the cavity (3) containing the phase change material (5) is surrounded by at least two coils (17, 18), and the at least two coils (17, 18) are oriented with respect to one another in such a way that magnetic fields (19) generated in the phase change material (5) by the coils (17, 18) can act in the same direction.

4. Apparatus according to one of Claims 1 to 3, **characterized in that** the magnetic field (19) generated in the phase change material (5) by the coils (17, 18) can be oriented perpendicularly with respect to a heat-emitting surface (13).

5. Apparatus according to one of Claims 1 to 4, **characterized in that** at least two cavities (3) containing phase change material (5) are arranged one behind the other in the direction of transport of the heat.

6. Apparatus according to one of Claims 1 to 5, **characterized in that** the coils (17, 18, 31) are accommodated in the housing.

7. Method for the cooling of a component (41), using an apparatus according to one of Claims 1 to 6, comprising the following steps:
(a) generation of a magnetic field (19) in the phase change material (5) by the application of current to the coils (17, 18),
(b) melting of part of the phase change material (5) by the absorption of heat on the side which faces the component (41) to be cooled,
(c) reversal of the magnetic field (19) by a reversal in the direction of application of current of the coils (17, 18, 31) and by the rotation of the non-melted part of the phase change material (5), with the result that the melted phase change material (5) is moved towards the heat-emitting surface (13) and solid phase change material (5) is moved towards the surface (11) at which heat is absorbed,
(d) melting of part of the solid phase change material (5) which faces the component (41) to be cooled and oriented solidification of the liquid phase change material (5), facing the heat-emitting surface (13), in the magnetic field (19) of the coils (17, 18, 31),
(e) if appropriate, repetition of steps (c) and (d).

8. Method according to Claim 7, **characterized in that** the heat flow supplied or discharged and the heat quantity absorbed or emitted are determined from the change in magnetization of the ferromagnetic or magnetizable particles (7) contained in the phase change material (5) on account of the phase change.

9. Method according to Claim 8, **characterized in that** the change in magnetization is determined from the variation of the coil inductances.

10. Method according to Claim 8 or 9, **characterized in that** the frequency at which the magnetic field is reversed is determined from the heat flow supplied or discharged and the heat quantity absorbed or emitted.

## Revendications

1. Dispositif pour refroidir des composants (41), comprenant un boîtier (1) avec une cavité (3) formée à l'intérieur de celui-ci, fermée à l'intérieur du boîtier (1), cavité dans laquelle est réceptionné un matériau de changement de phase (5), le boîtier (1) présentant au moins une surface (11), qui peut être mise en contact avec le composant (41) à refroidir, et au moins une surface (13) dégageant de la chaleur, **caractérisé en ce que** la cavité (3) contenant le matériau de changement de phase (5) est entourée par au moins une bobine (17, 18) et le matériau de changement de phase (5) contient des particules (7) ferromagnétiques ou magnétisables.

2. Dispositif selon la revendication 1, **caractérisé en ce que** la cavité (3) contenant le matériau de changement de phase (5) est conçue avec une section transversale circulaire.

3. Dispositif selon la revendication 1 ou 2, **caractérisé en ce que** la cavité (3) contenant le matériau de changement de phase (5) est entourée par au moins deux bobines (17, 18) et les au moins deux bobines (17, 18) sont orientées l'une par rapport à l'autre de telle sorte que des champs magnétiques (19) générés par les bobines (17, 18) peuvent être orientés dans le même sens dans le matériau de changement de phase (5).

4. Dispositif selon l'une quelconque des revendications 1 à 3, **caractérisé en ce que** le champ magnétique (19) généré par les bobines (17, 18) dans le matériau de changement de phase (5) peut être orienté perpendiculairement à une surface (13) dégageant de la chaleur.

5. Dispositif selon l'une quelconque des revendications 1 à 4, **caractérisé en ce qu'**au moins deux cavités (3) contenant du matériau de changement de phase (5) sont disposées les unes derrière les autres dans le sens de transport de la chaleur.

6. Dispositif selon l'une quelconque des revendications 1 à 5, **caractérisé en ce que** les bobines (17, 18, 31) sont réceptionnées dans le boîtier.

7. Procédé pour refroidir un composant (41) en utilisant un dispositif selon l'une quelconque des revendications 1 à 6, comprenant les étapes suivantes :
(a) génération d'un champ magnétique (19) dans le matériau de changement de phase (5) par alimentation en courant des bobines (17, 18),
(b) fusion d'une partie du matériau de changement de phase (5) par absorption de chaleur sur le côté qui est tourné vers le composant (41) à refroidir,
(c) inversion du champ magnétique (19) par inversion du sens de l'alimentation en courant des bobines (17, 18, 31) et rotation de la partie non fondue du matériau de changement de phase (5), de sorte que le matériau de changement de phase (5) fondu est déplacé en direction de la surface (13) dégageant de la chaleur et du matériau de changement de phase (5) solide est déplacé en direction de la surface (11) sur laquelle est absorbée de la chaleur,
(d) fusion d'une partie du matériau de changement de phase (5) solide, qui est tourné vers le composant (41) à refroidir, et solidification orientée du matériau de changement de phase (5) liquide, tourné vers la surface (13) dégageant de la chaleur, dans le champ magnétique (19) des bobines (17, 18, 31),
(e) éventuellement répétition des étapes (c) et (d).

8. Procédé selon la revendication 7, **caractérisé en ce que** le flux de chaleur amené ou évacué et la quantité de chaleur absorbée ou dégagée sont déterminés à partir de la variation de la magnétisation des particules (7) ferromagnétiques ou magnétisables contenues dans le matériau de changement de phase (5) à la suite du changement de phase.

9. Procédé selon la revendication 8, **caractérisé en ce que** la variation de la magnétisation est déterminée à partir de la variation des inductances de bobine.

10. Procédé selon la revendication 8 ou 9, **caractérisé en ce qu'**on détermine à partir du flux de chaleur amené ou évacué et de la quantité de chaleur absorbée ou dégagée dans quelle fréquence le champ magnétique est inversé.
